(19) **Europäisches Patentamt / European Patent Office / Office européen des brevets**

(11) **EP 3 057 123 B1**

(12) **EUROPEAN PATENT SPECIFICATION**

(45) Date of publication and mention
of the grant of the patent:
**08.12.2021 Bulletin 2021/49**

(51) Int Cl.:
*H01L 23/488* (2006.01)   *H01L 23/498* (2006.01)
*H01L 23/373* (2006.01)   *H01L 21/60* (2006.01)
*H01L 21/48* (2006.01)

(21) Application number: **14851457.3**

(22) Date of filing: **03.10.2014**

(86) International application number:
**PCT/JP2014/076570**

(87) International publication number:
**WO 2015/053193 (16.04.2015 Gazette 2015/15)**

(54) **JOINING STRUCTURE COMPRISING LAYERS WITH DIFFERENT AVERAGE CRYSTAL GRAIN SIZES FOR A SEMICONDUCTOR CHIP**

VERBINDUNGSSTRUKTUR MIT SCHICHTEN MIT UNTERSCHIEDLICHEN DURCHSCHNITTLICHEN KRISTALLKÖRNERGRÖSSEN FÜR EINEN HALBLEITERCHIP

STRUCTURE D'INTERCONNEXION COMPRENANT DES COUCHES AVEC DES GRAINS CRISTALLINS DE DIMENSIONS MOYENNES DIFFÉRENTES POUR UNE PUCE À SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.10.2013 JP 2013210555**

(43) Date of publication of application:
**17.08.2016 Bulletin 2016/33**

(73) Proprietor: **Furukawa Electric Co., Ltd.**
**Chiyoda-ku**
**Tokyo 100-8322 (JP)**

(72) Inventors:
 • **KOJIMA Naoyuki**
  **Tokyo 100-8322 (JP)**
 • **HIKASA Kazuhito**
  **Tokyo 100-8322 (JP)**
 • **SATO Shunichiro**
  **Tokyo 100-8322 (JP)**
 • **FUJIWARA Hidemichi**
  **Tokyo 100-8322 (JP)**
 • **WATANABE Masato**
  **Tokyo 100-8322 (JP)**

(74) Representative: **Glück Kritzenberger**
**Patentanwälte PartGmbB**
**Hermann-Köhl-Strasse 2a**
**93049 Regensburg (DE)**

(56) References cited:
 **EP-A1- 2 298 471   EP-A2- 2 388 810**
 **EP-A2- 2 738 795   WO-A1-2012/029772**
 **WO-A1-2012/081255   WO-A1-2014/038128**
 **WO-A1-2014/048502   WO-A2-2009/094537**
 **JP-A- 2006 282 417   JP-A- 2011 003 565**
 **JP-A- 2012 204 523   JP-A- 2013 041 884**
 **JP-A- 2013 209 720**

 • **TEI ET AL: "Materialographie / Lichtmikroskopie (LiMiMat)" In: October 2013 (2013-10), TU Ilmenau, Fakultät für Elektrotechnik und Informationstechnik, Institut für Werkstofftechnik, XP055702721, pages 1-10,**
 • **MERTENS CH: "Die Niedertemperatur-Verbindungstechnik der Leistungselektronik (book series: Fortschritt-Berichte VDI, Reihe 21, Elektrotechnik, Nr. 365), Chapter 3: Physikalisch-chemischer Hintergrund des NTV-Prozesses", 2004, VDI Verlag, Düsseldorf, Germany, XP001526267, ISBN: 978-3-18-336521-0 pages 37-72,**

**Description**

Technical Field

The present invention relates to a joining structure according to claim 1.

Background Art

Solder is generally used for connecting a semiconductor device that controls or supplies power (a so-called power semiconductor device) to a substrate such as a circuit board or a ceramic substrate or to a wiring member such as a lead frame. Commonly-used solder for such a purpose is solder cream, which is made to have suitable viscosity by adding flux to solder powder. However, when flux is used, the surface of the semiconductor device could be contaminated, and there is a problem that a cleaning step becomes necessary. Further, in recent years, considering environmental impact, it is required to use lead-free solder materials that do not contain lead. Au-Sn solder is known as a lead-free solder material which can withstand heat generation by a power semiconductor device, but it is expensive and thus not practical. Sn-Ag-Cu solder is a solder material that is less expensive than Au-Sn solder, but has a problem that a growth of an intermetallic compound due to thermal history may lead to a decrease in reliability.

As a joining member free of solder, Anisotropic Conductive Film (ACF) is also known that is a film formed of a mixture of a thermosetting resin and fine metal particles having conductivity. However, there is a concern that the thermosetting resin may degrade due to high heat, and thus an ACF is not suitable for connecting power semiconductor devices that produce a large amount of heat.

As another joining member free of solder, an Ag paste obtained by dispersing Ag particles in a resin has been proposed. When using an Ag paste as a joining member for a power semiconductor device, high thermal conductivity and high electric conductivity are required. Thus, it is necessary to increase the content of Ag in the paste. However, as the content of Ag becomes greater, the ratio of resin which is likely to show elastic deformation becomes smaller. Accordingly, rigidity of the joining layer after the curing process increases, and a strain absorbing capability of the joining layer decreases. When a strain greater than the strain absorbing capability is applied to such joining layer, there is a problem that a defect may occur at a contact interface between an electrode or a die pad of the semiconductor device and Ag particles, and thus peeling may occur.

Further, in a case where an electrode of the semiconductor device or an electrode of the substrate contains Ni and an Ag paste is used as a joining member, joining strength (adhesiveness) is low, and thus there is a problem that the interface may break due to an external force during handling and a required long-term reliability cannot be achieved. Thus, it is necessary to apply a noble metal plating on an electrode of the semiconductor device or an electrode of the substrate. However, when joining is performed as described above by applying a noble metal plating, a thermal stress on the semiconductor chip due to a difference in thermal expansion between the members increases, and thus there is a problem of a decrease in durability.

Accordingly, recently, it is known to supply metal particles coated with an organic material and having an average particle diameter of less than or equal to 100 nm between the materials to be joined, and joining them by decomposing the organic material by heating and sintering the metal particles with each other (e.g., Patent Document 1).

Further, it is proposed to join members to be joined by forming an oxide layer containing oxygen at a joining interface of the members to be joined, disposing a joining material including metal compound particles having an average particle diameter of greater than or equal to 1 nm and less than or equal to 50 $\mu$m and a reducing agent composed of an organic material, and heating and applying a pressure between the members to be joined (e.g., Patent Document 2). It is described that, with this configuration, metal compound particles are reduced at a temperature lower than that of the case of heating and decomposing the metal compound particles as a single body, and metal particles having an average particle diameter of less than or equal to 100 nm are produced. Further, it is disclosed that, after having produced an oxide layer on a joining face prior to the joining, an oxidizing process is applied on this layer to produce an oxidized layer having a thickness greater than or equal to a thickness of a naturally oxidized layer, to thereby efficiently perform discharging of an oxide in the joined material during the joining, and thus a shearing strength of the joining face can be increased.

Also, it is proposed to connect two metal surfaces with each other after having applied a treatment on the two metal surfaces, such that a connection having conductivity can be formed by substitution diffusion between the same metal ions and/or metal atoms. (E.g., Patent Document 3).

Document List

Patent Document(s)

[Patent Document 1] Japanese Laid-Open Patent Publication 2004-107728
[Patent Document 2] Japanese Laid-Open Patent Publication 2008-208442
[Patent Document 3] Japanese Laid-Open Patent Publication 2013-524494

EP 2 388 810 A2 discloses a joining structure according to the preamble of claim 1.
WO 2012/029772 A1 discloses a solar cell lead wire made of copper, with crystal grain size at the surface layer smaller than the crystal grain size at the inner layer.

Summary of Invention

Technical Problem

With the configurations of Patent Documents 1 and 2, however, in joining by metal particles, there is a large difference in crystal grain size between a paste connection part of the metal fine particles and copper of the metal member as compared to joining between metal particles, and thus there is a problem that a strain concentration (difference in yield strain) occurs at an interface thereof, and a crack initiation point is likely to occur when strain is applied repeatedly. Further, the configuration of Patent Document 3 does not disclose a crystal grain size in the vicinity of an interface of the two metal surfaces.
It is an object of the present invention to provide a joining structure and an electronic member joining structural body that prevents crack initiation at a joining portion between a metal member and a metal porous body, and can achieve a highly reliable joining.

Solution to Problem

In order to achieve the above object, a joining structure comprises features as in claim 1. Preferred embodiments of the invention are the subject of the dependent claims.

Effects of Invention

According to the joining structure of the present invention, since a yield strain continuously varies in a thickness direction of a laminated body, a strain concentration is suppressed, and thus a crack initiation point is less likely to occur when strain is applied repeatedly. Also, since the crystal grain size of an inner layer of the metal member is large, an overall strain relaxation effect is great. Therefore, crack initiation at a joining portion of a metal member and a metal porous body is prevented, and reliable joining can be achieved.

Brief Description of Drawings

[Fig. 1] Fig. 1 is a cross sectional view schematically showing a joining structure according to an embodiment of the present invention.
[FIG. 2] Fig. 2 is an enlarged cross sectional schematic view of an interface portion of a metal porous body and a metal member for explanation of the joining structure according to an embodiment of the present invention.
[FIG. 3] Figs. 3A to 3C are diagrams showing a method of forming a joining structure according to an embodiment of the present invention.
[FIG. 4] Fig. 4A is a cross-sectional view of an embodiment not forming part of the claimed invention and Fig. 4B is a cross sectional view of a joining structure according to another embodiment of the present invention.
[FIG. 5] Fig. 5 is a diagram for explaining a calculation method of a crystal grain size.

Description of the Embodiments

Hereinafter, embodiments will be described in detail with reference to the attached drawings. Only those embodiments which concern a metal member made of copper, the metal member being a metal layer formed directly on a ceramic substrate or a metal layer formed directly on a metal thin film, the metal thin film being formed directly on a ceramic substrate, wherein a metal porous body is made of silver and is formed directly on the metal member and wherein an electronic member is a semiconductor chip are to be considered embodiments of the invention. The other embodiments do not form part of the invention but are useful for understanding the claimed invention.

[Present Embodiment]

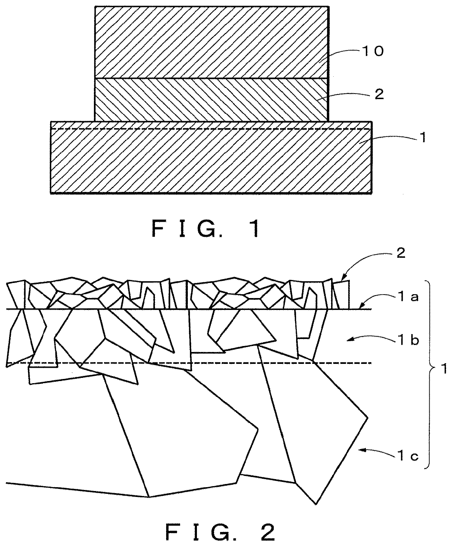

Fig. 1 is a cross sectional view schematically showing a joining structure according to the present embodiment. As shown in Fig. 1, the joining structure of the present embodiment includes a metal member 1, and a metal porous body 2 formed on one of main surfaces of the metal member 1. On the metal porous body 2, a semiconductor chip 10 is disposed.

The metal member 1 is not particularly limited as long as it is a member containing metal, and may be, for example, a substrate such as a circuit board, a lead frame, or a connector member. It is preferable that the metal member is composed of a metal material such as Cu or Cu alloy, or Ag or Ag alloy. A circuit board may be a DBC (Direct Bonding Copper) substrate or an AMC (Active-metal brazed copper) substrate wherein a copper sheet is joined to a ceramic substrate. Alumina ($Al_2O_3$) may be used as a ceramic of a DBC substrate, and silicon nitride ($Si_3N_4$) or aluminum nitride (AIN) may be used as a ceramic of an AMC substrate.

The metal porous body 2 is formed by sintering a metal fine particle dispersion containing metal fine particles and an organic dispersion medium. It is preferable that the metal fine particles are: fine particles composed of one of metals selected from a group of metal elements consisting of Cu, Ag, Au, Al, Ni, Pt, Sn, Sb and Pd; fine particles which are a mixture of two or more metals selected from the aforementioned group of metal elements; fine particles composed of an alloy of two or more elements selected from the aforementioned group of metal elements; fine particles which are a mixture of fine particles of one element selected from the aforementioned group of metal elements or fine particles of a mixture of two or more elements selected from the aforementioned group of metal elements and fine particles composed of an alloy of two or more elements selected from the aforementioned group of metal elements. Also, the metal fine particles may be fine particles composed of an oxide of the aforementioned metals or fine particles composed of an oxide of the aforementioned alloy, or the oxide may be a part of the fine particles.

It is preferable that an average particle diameter (average particle diameter of primary particles) of the metal fine particles is greater than or equal to 5 nm and less than or equal to 200 nm. As used herein, "an average particle diameter of the primary particles" means an average of the diameters of the primary particles which are individual metal fine particles constituting a secondary particle. A primary particle size can be measured using an electron microscope. Also, the average particle diameter means a number average particle size of the primary particles. With the average particle diameter of the metal fine particle being greater than or equal to 5 nm, a metal porous body having a homogeneous crystal grain size and pores after baking can be obtained.

The organic dispersion medium is preferably polyalcohol, and more preferably, one or two or more polyol having two or more hydroxyl groups in a molecule. Specifically, polyol may be one or two or more selected from ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerin, and 2-methyl-2,4-pentanediol.

The metal fine particle dispersion may contain a dispersion aid substance and/or solvent as appropriate. As a dispersion aid substance, a known substance may be used as appropriate, and considering improvements in dispersibility and sinterability of the metal fine particles, it is desirable to use compounds having an amide group, amine compound, etc.

Fig. 2 is an enlarged cross sectional schematic view for explanation of the joining structure according to an embodiment of the present invention. As shown in Fig. 2, the metal member 1 has an outer layer 1b including one of the main surfaces 1a and formed on the metal porous body 2 side, and an inner layer 1c formed at a position (including the other main surface) farther from the metal porous body 2 than the outer layer 1b in a thickness direction. In Fig. 2, the boundary between the outer layer 1b and the inner layer 1c is indicated by a broken line, but this is for the sake of ease of explanation, and in practice, a certain unevenness is formed at the boundary. An average crystal grain size ds of the outer layer 1b is smaller than an average crystal grain size di of the inner layer 1c, and an average crystal grain size dp of the metal porous body 2 is smaller than or equal to an average crystal grain size ds of the outer layer 1b (dp $\leq$ ds < di). It is preferable that the average crystal grain size ds and the average crystal grain size dp satisfy the following equation:

$$1 \leq ds/dp < 100 \, .$$

Since the average crystal grain size ds of the outer layer 1b is smaller than the average crystal grain size di of the inner layer 1c, and the average crystal grain size dp of the metal porous body 2 is smaller than or equal to the average crystal grain size ds of the outer layer 1b, a yield strain continuously varies and thus a strain concentration is suppressed, and a crack initiation point is less likely to occur when strain is applied repeatedly. Also, since the average crystal grain size di of inner layer 1c is large, an overall strain relaxation effect is great. Also, with ds/dp < 100, the average crystal grain size dp of the metal porous body 2 does not become excessively smaller than the average crystal grain size ds of the outer layer 1b, and the yield strain is likely to vary continuously, a strain concentration is suppressed, and the crack initiation point is less likely to occur when strain is applied repeatedly.

It is preferable that the outer layer 1b has an average crystal grain size ds of greater than or equal to 0.2 $\mu$m and less than 10 $\mu$m. With the average crystal grain size ds of less than 0.2 $\mu$m, the yield strain is large, and thus the stress concentrates at an interface (main surface 1a) between the metal porous body 2 and the outer layer 1b, and a crack is likely to occur. On the other hand, with the average crystal grain size ds that is greater than or equal to 10 $\mu$m, the average crystal grain size ds of the outer layer 1b is excessively greater than the average crystal grain size dp of the metal porous body 2, and thus a continuous yield strain is not obtained at the interface between the metal porous body 2 and the outer layer 1b, and a crack is likely to occur when strain is applied repeatedly. It is preferable that the outer layer 1b has a thickness of greater than or equal to 0.5 $\mu$m and less than or equal to 10 $\mu$m, but should not be limited thereto.

It is preferable that the inner layer 1c has an average crystal grain size di of greater than or equal to 10 $\mu$m and less than or equal to 100 $\mu$m. In a case where the average crystal grain size di of less than 10 $\mu$m, an overall distortion relaxation effect of the metal porous body 2 and the metal member 1 becomes small. On the other hand, in a case where the average crystal grain size di being greater than or equal to 100 $\mu$m, the average crystal grain size di of the inner layer 1c becomes excessively greater than the average crystal grain size ds of the outer layer 1b, and a continuous yield strain is not obtained in the metal member 1, and a crack is likely to occur when strain is applied repeatedly.

It is preferable that the average crystal grain size dp of the metal porous body 2 is less than or equal to 1 $\mu$m and greater than or equal to 0.1 $\mu$m. In a case where the average crystal grain size dp is less than 0.1 $\mu$m, sintering of the metal porous body 2 will be insufficient, and the bonding between the metal particles is likely to be weak. On the other hand, in a case where the average crystal grain size dp is greater than 1 $\mu$m, since metal diffusion of the metal fine particles has progressed, microvoids in the metal porous body 2 decrease and the rigidity of the metal porous body 2 as a whole increases. Thus, a stress load on an electronic member (e.g., semiconductor chip), which is an object to be connected, increases. In a case where the metal material composing the metal porous body 2 is Ag or Ag alloy, the average crystal grain size dp of the metal porous body 2 may be greater than 1 $\mu$m.

A method of joining the semiconductor chip 10 with the metal member 1 via the metal porous body 2 will now be described.

First, a process of forming the outer layer 1b at the main surface 1a of the metal member 1 is performed. By forming the outer layer 1b, atomic vacancy and/or dislocation is produced at a surface of the metal member 1, and it is preferably carried out by mechanical processing such as grinding by blasting or buffing. In the case of the grinding by blasting, an abrasive material may be glass beads, alumina beads, and zirconia beads. The shape of the abrasive material may be spherical or polygonal, but should not be limited thereto.

The thickness of outer layer 1b is preferably greater than or equal to 0.5 $\mu$m and less than or equal to 10 $\mu$m, but should not be limited thereto. The surface roughness Ra of the outer layer 1b is preferably greater than or equal to 0.1 $\mu$m and less than or equal to 2.0 $\mu$m, but should not be limited thereto.

Further, a thermal treatment may be performed prior to the process of forming the outer layer 1b on the main surface 1a of the metal member 1. By performing a thermal treatment, recrystallization of the metal member 1 is accelerated, and the crystal grain size can be increased. Considering the recrystallization, the thermal treatment condition is preferably about 300 °C to 400 °C for less than or equal to 1 hour.

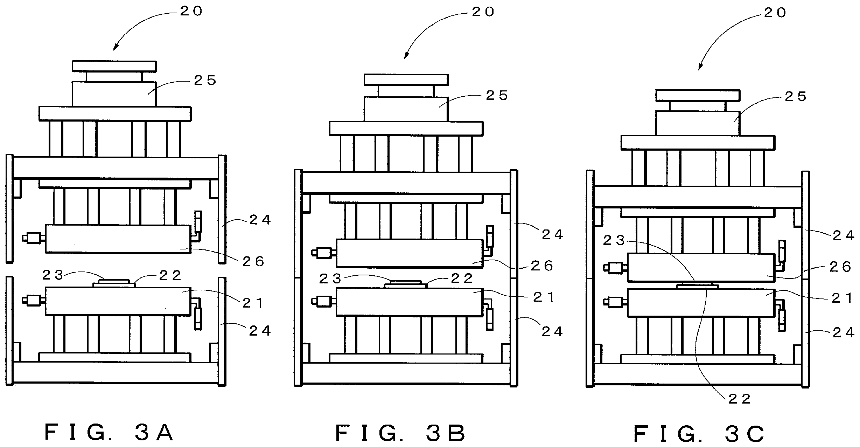

Then, metal fine particle dispersion is applied to the metal member 1 and predrying is performed by heating at 100 °C to 150 °C for 5 to 20 minutes. A semiconductor chip 10 is placed on a metal member on which metal fine particles is placed. Then, a laminated body including the metal member 1, the metal porous body 2, and the semiconductor chip 10 placed on top of each other in this order is set in a sintering apparatus as shown in Figs. 3A to 3C.

Figs. 3A to 3C are drawings indicating a method of forming a joining structure according to the present embodiment. As shown in Fig. 3A, a pressing plate 22 for laying up is placed on a lower heating platen 21 of a sintering apparatus 20 and a laminated body 23 is placed thereon. A pressing plate 22 is a plate composed of, for example, Teflon (registered trademark), polyimide, and 42 alloy. Pressing plates for laying up may be placed above and below the laminated body 23.

Then, a chamber 24 is closed, and an inert atmosphere is created in the chamber 24 (Fig. 3B). An inert atmosphere is an atmosphere which is filled with an inactive gas such as nitrogen, or a vacuum atmosphere. By creating an inert atmosphere in the chamber 24, it is possible to remove an oxidization layer on a surface of metal fine particles and sinterability of the metal fine particles can be improved.

Then, as shown in Fig. 3C, the laminated body 23 is sandwiched between the lower heating platen 21 and an upper heating platen 26 and heated and baked while applying a pressure with a press cylinder 25. The sintering temperature is preferably greater than or equal to 150 °C and less than or equal to 400 °C. The pressure during sintering is preferably greater than or equal to 5 MPa and less than or equal to 20 MPa, and the sintering time is preferably greater than 0 (zero) minutes and less than 20 minutes. The sintering time is preferably less than or equal to 15 minutes, since the shorter the sintering time, the average crystal grain size ds of the outer layer 1b of the metal member 1 can be made smaller than the average crystal grain size di of the inner layer 1c, and also can be made greater than or equal to the average crystal grain size dp of the metal porous body. By this baking, the metal fine particles in the laminated body 23 are sintered, and a metal porous body 2 is formed between the metal member 1 and the semiconductor chip 10.

Heat treatment may be further performed after having sintered the metal fine particles. By performing heat treatment, diffusion joining is accelerated. To obtain sufficient diffusion joining, the heat treatment condition is preferably around 300 °C to 500 °C for 30 minutes to one hour. The crystal grain size increases as a result of accelerated recrystallization.

As set forth above, according to the joining structure of the present embodiment, the average crystal grain size ds of the outer layer 1b of the metal member 1 is smaller than the average crystal grain size di of the inner layer 1c, and the average crystal grain size dp of the metal porous body 2 is smaller than or equal to the average crystal grain size ds of the outer layer 1b. Thereby, since yield strain continuously varies in the thickness direction of the joining, a strain concentration is suppressed, and a crack initiation point is less likely to occur when strain is applied repeatedly. Also, since the crystal grain size of the inner layer of the metal member 1 is large, an overall strain relaxation effect is large. Particularly, it is possible to prevent propagation of a crack formed laterally along an interface between the metal member 1 and the metal porous body 2.

[Other Embodiments]

In the present embodiment, the metal porous body 2 is formed on one of the main surfaces 1a of the metal member 1, but the metal porous body may be formed on both main surfaces of the metal member 1.

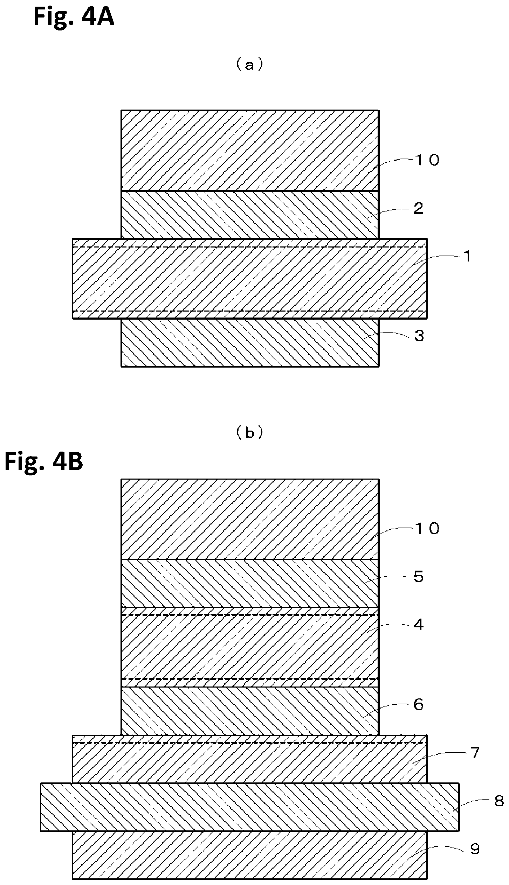

For example, the joining structure shown in Fig. 4A has a metal member 1, a metal porous body 2 formed on one of the main surfaces of the metal member 1, a semiconductor chip 10 formed on the metal porous body 2, and a metal porous body 3 formed on the other main surface of the metal member 1. The metal member 1 has a first outer layer including the main surface on the metal porous body 2 side, and further has a second outer layer including the main surface on the metal porous body 3 side. Further, a first inner layer is formed between the first outer layer and the second outer layer. An average crystal grain size $ds_{12}$ of the first outer layer of the metal member 1 is smaller than an average crystal grain size $di_1$ of the first inner layer of the metal member 1, and an average crystal grain size $dp_2$ of the metal porous body 2 is smaller than or equal to an average crystal grain size $ds_{12}$ of the first outer layer of the metal member 1 ($dp_2 \leq ds_{12} < di_1$). An average crystal grain size $ds_{13}$ of the second outer layer of the metal member 1 is smaller than the average crystal grain size $di_1$ of the first inner layer of the metal member 1 ($ds_{13} < di_1$). In this case, mechanical processing such as blasting is applied on both main surfaces of the metal member 1. According to the configuration shown in Fig. 4A, occurrence of crack at the joining portion formed on both faces of the metal member 1 can be prevented.

A joining structure shown in Fig. 4B has a thick copper sheet 4, a metal porous body 5 formed on one of the main surfaces of the thick copper sheet 4, and a semiconductor chip 10 formed on the metal porous body 5, and further, on the other main surface of the thick copper sheet 4, a metal porous body 6, a copper sheet 7, a ceramic sheet 8 and a copper sheet 9 are laminated in this order. The thick copper sheet 4 has a first outer layer including a main surface on the metal porous body 5 side, and further has a second outer layer including a main surface on the metal porous body 6 side. Further, a first inner layer is formed between the first outer layer and the second outer layer. An average crystal grain size $ds_{45}$ of the first outer layer of the thick copper sheet 4 is smaller than an average crystal grain size $di_4$ of the first inner layer of the thick copper sheet 4, and an average crystal grain size $dp_5$ of the metal porous body 5 is smaller than or equal to an average crystal grain size $ds_{45}$ of the first outer layer ($dp_5 \leq ds_{45} < di_4$). An average crystal grain size $ds_{46}$ of the second outer layer of the thick copper sheet 4 is smaller than an average crystal grain size $di_4$ of the first inner layer of the thick copper sheet 4, and an average crystal grain size $dp_6$ of the metal porous body 6 is smaller than or equal to an average crystal grain size $ds_{46}$ of the second outer layer of the thick copper sheet 4 ($dp_6 \leq ds_{46} < di_4$).

Further, the copper sheet 7 has a third outer layer including a main surface on the metal porous body 6 side, and a third inner layer formed at a position farther from the metal porous body 6 than the third outer layer in a thickness direction and on the ceramic sheet 8 side. An average crystal grain size $ds_{76}$ of the third outer layer of the copper sheet 7 is smaller than an average crystal grain size $di_7$ of the third inner layer of the copper sheet 7, and an average crystal grain size $dp_6$ of the metal porous body 6 is smaller than or equal to the average crystal grain size $ds_{76}$ of the third outer layer of the copper sheet 7 ($dp_6 \leq ds_{76} < di_7$). In this case, mechanical processing such as blasting is applied on the metal porous body 6 side main surface and the metal porous body 5 side main surface (both faces) of the thick copper sheet 4 and on the metal porous body 6 side main surface of the copper sheet 7. According to the configuration of Fig. 4B, occurrence of a crack can be suppressed not only at the joining portion formed on one of the faces of the metal porous body 5, but also at the joining portions formed on both faces of metal porous body 6.

Note that, an electrode layer, not shown, may be provided between the metal porous body 2, 5 and the semiconductor chip 10. For example, the electrode layer is composed of one or more of Au, Ag, Cu, Pd, and Pt.

EXAMPLES

Hereinafter, preferred embodiments will be described in detail based on examples and comparative examples, but the present invention is not limited to these examples, the invention being defined by appended independent claim 1.

Hereinafter, (1) raw materials, (2) an apparatus, and (3) an evaluation method used for Examples and Comparative Examples will be described.

(1) Raw Materials

(A) Semiconductor Chip

A semiconductor chip has a size of 7 mm × 7 mm and a thickness of 230 $\mu$m, and its joining face is metalized with Ni-Ti-Au alloy. The material is SiC.

(B) Metal Fine Particle Dispersion

Copper fine particle dispersion: A copper fine particle dispersion in which copper fine particles are dispersed in diethylene glycol at a Cu concentration of 80 mass% was used. The copper fine particle dispersion contains 0.3 mass% polyvinylpyrrolidone blended therein as a high polymer dispersing agent.

Silver fine particle dispersion: A silver fine particle dispersion in which silver fine particles are dispersed in octanediol at an Ag concentration of 89 mass% (silver nano paste manufactured by DOWA METALTECH CO., LTD.) was used.

(C) Metal Member (Metal Substrate)

(i) Ceramic Substrate (DBC)

DBC substrate ($Cu/Al_2O_3$ (alumina) /Cu) manufactured by NIPPON STEEL & SUMIKIN Electronics Devices Inc. was used. It had Cu sheet thickness 0.3 mm/ceramic sheet thickness 0.32 mm/Cu sheet thickness 0.3 mm.

(ii) Ceramic Substrate (Thin Film + Plating)

Ni·Cr/Cu (0.2 $\mu$m/6 $\mu$m) was deposited onto a white ceramic substrate of $Al_2O_3$ (alumina) having a thickness of 0.64 mm, and thereafter, thickened under the following plating condition until Cu has a thickness 0.3 mm for both faces:

Plating Solution: $CuSO_4·5H_2O$ 250 g/L (water), $H_2SO_4$ 50 g/L (water), NaCl 0.1 g/L (water)
Electric current density: 5A/dm$^2$, temperature 40 °C

(iii) Lead Frame Material

Oxygen-free copper C1020 was used. Thickness was 1.2 mm.

(iv) Laminated DBC Substrate (Thick Copper Sheet)

DBC substrate ($Cu/Al_2O_3$ (alumina)/Cu) manufactured by NIPPON STEEL & SUMIKIN Electronics Devices Inc. was used. It had Cu sheet thickness: 0.3 mm/ceramic sheet thickness: 0.32 mm/Cu sheet thickness 0.3 mm.

One of the surfaces of one copper sheet 7 of the DBC substrate was cleaned, and thereafter, processed by a wet blast (WB) method using a medium of alumina beads having a particle diameter of 40 $\mu$m with a pressure of 0.20 MPa and a processing speed of 10 mm/sec. Then, a copper fine particle dispersion was applied to a WB-processed surface such that the dispersion has a thickness of 100 $\mu$m, and dried at 110 °C for 15 minutes. Further, a thick copper sheet 4 having a thickness of 0.3 mm was mounted on a copper fine particle dispersion layer obtained by the drying process, and set in a sintering apparatus. Sintering was performed under a reduced pressure atmosphere (oxygen concentration less than or equal to 1,000 ppm), at 300 °C, under a pressure of 10 MPa for 15 minutes to form a metal porous body 6 between the thick copper sheet 4 and the copper sheet 7 of the DBC substrate.

(v) Laminated DBC Substrate (Copper Foil with Plated Layer)

DBC substrate (Cu/Al$_2$O$_3$ (alumina)/Cu) manufactured by NIPPON STEEL & SUMIKIN Electronics Devices Inc. was used. It had Cu sheet thickness: 0.3 mm/ceramic sheet thickness: 0.32 mm/Cu sheet thickness 0.3 mm.

A copper foil having a thickness of 0.1 mm was heat-treated at 500 °C for one hour, and thereafter, a plating layer having a thickness of 0.1 mm was formed on both surfaces of the copper foil under plating conditions described below to form a thick copper sheet 4.

One of the surfaces of the copper sheet 7 of the DBC substrate was cleaned, and thereafter, processed by a wet blast (WB) method using a medium of alumina beads having a particle diameter of 40 $\mu$m with a pressure of 0.20 MPa and a processing speed of 10 mm/sec. Then, a copper fine particle dispersion was applied to a WB-processed surface such that the dispersion had a thickness of 100 $\mu$m, and dried at 110 °C for 15 minutes. Further, the copper foil with plating layer obtained by forming a plating layer on both surfaces of the copper foil was mounted on a copper fine particle dispersion layer obtained by the drying process and set in a sintering apparatus. Sintering was performed under a reduced pressure atmosphere (oxygen concentration less than or equal to 1,000 ppm), at 300 °C, under a pressure of 10 MPa for 15 minutes to form a metal porous body 6 between the thick copper sheet 4 and the copper sheet 7 of the DBC substrate. Plating solution: CuSO$_4$·5H$_2$O 250 g/L (water), H$_2$SO$_4$ 50 g/L (water), NaCl 0.1 g/L (water). Electric current density: 5A/dm$^2$, temperature 40 °C.

(2) Apparatus

A sintering apparatus shown in Figs. 3A to 3C was used.

(3) Evaluation Method

(A) Surface Roughness of Metal Member

It was measured with a laser microscope (KEYENCE VK9710).

(B) Average Crystal Grain Size dp of Metal Porous Body

A sample was fabricated which included a porous body and a semiconductor chip formed on a metal member, and ground on its semiconductor chip side until about 10 $\mu$m of the semiconductor chip was remaining. Thereafter, it was processed by Ga beam etching using a nano-processing microscope system (FIB apparatus; Manufactured by SII Nano Technology Corporation SMI3050TB) until the thickness was 50 nm, and a sample was cut out by cutting with a microprobe. This sample was set in TEM (JEM3010 manufactured by JEOL), a TEM image was obtained under the conditions of an acceleration voltage of 200 KV and a magnification of x5,000 for observing the crystal grain size of the metal porous body. In a TEM image, a straight line (a) was drawn in the middle of the thickness direction of the metal porous body using a software accompanying the TEM (JEM3010 manufactured by JEOL), and an average value of (length + breadth)/2 for twenty crystals existing on the straight line (a) was calculated. The straight line (a) was drawn as follows.

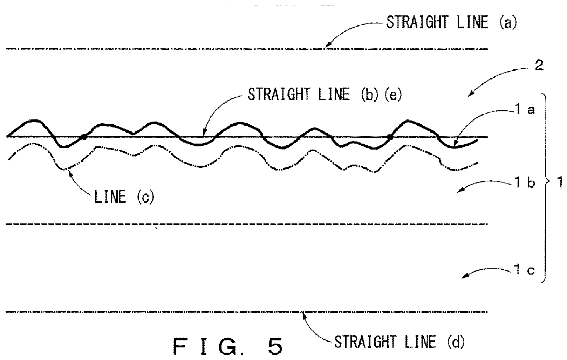

First, at an interface between the metal substrate and the metal porous body, two points were selected such that a straight line distance between them corresponded to the thickness of the metal porous body, and a straight line (b) connecting the two points was drawn. Then, at a position spaced apart by half the thickness of the metal porous body from the straight line (b) in a thickness direction of the metal porous body, a straight line (a) which was a straight line parallel to the straight line (b) was drawn (Fig. 5).

(C) Average Crystal Grain Size ds of Outer Layer

Using a TEM under the same conditions as in (B), a sample obtained similarly to (B) was used for observing the crystal grain size of the outer layer of the metal member. In a TEM image, at a position at a distance of 1 $\mu$m from an interface between the metal porous body and the metal member to the metal member side, a line (c) was drawn along the interface. An average value of (length + breadth)/2 for twenty crystals existing on the line (c) was calculated (Fig. 5).

(D) Average Crystal Grain Size di of Inner Layer

Using a TEM under the same conditions as in (B), a sample obtained similarly to (B) was used for observing the crystal grain size of the inner layer of the metal member. In a TEM image, a straight line (d) was drawn in the middle in the thickness direction of the metal member. An average value of (length + breadth)/2 for twenty crystals existing on the straight line (d) was calculated. The straight line (d) was drawn as follows.

First, at an interface between the metal substrate and the metal porous body, two points were selected such that a straight line distance between them corresponded to the thickness of the metal member, and a straight line (e) connecting the two points was drawn. Then, at a position spaced apart by half the thickness of the metal member from the straight line (e) in a thickness direction of the metal member, a straight line (d) which was a straight line parallel to the straight line (e) was drawn (Fig. 5).

(E) Thermal Cycle Test (TCT)

A sample was fabricated which included a metal porous body and a semiconductor chip that were formed on a metal member. The sample was subjected to a thermal cycle test (a cycling test in which 150 °C is maintained for 30 minutes and thereafter -40 °C is maintained for 30 minutes), and observed with an ultra-sonic testing machine (SAT) every 100 cycles. Using an ultra-sonic testing machine (manufactured by Hitachi Construction Machinery Co., Ltd., Mi-Scope) and a probe (model PQ2-13, 50MHz), an ultrasonic wave was irradiated from the semiconductor device side, and adjusted by a gate such that it entered from a reverse face of the semiconductor device to the front face of the metal member surface by a reflection method, and measurement was carried out to check whether there are any defects such as peeling or a void in the joining face or in the metal porous body. The test was repeated until peeling was observed in an area of greater than or equal to 10% of the area of a joining face between the metal member and the metal porous body. An average value for twenty samples was calculated for the number of cycles before peeling.

For metal members having a ceramic substrate, an average number of cycles of greater than or equal to 1000 was defined as "acceptable", and less than 1000 was defined as "not acceptable". For metal members that is a lead frame material, an average number of cycles of greater than or equal to 500 was defined as "acceptable", and less than 500 was defined as "not acceptable".

[Example 1-1] (not covered by the invention as defined in the claims)

A surface of a copper sheet of a DBC substrate was cleaned, and thereafter, processed by a wet blast (WB) method using a medium of alumina beads having a particle diameter of 14 μm with a pressure of 0.20 MPa and a processing speed of 20 mm/sec. Then, a copper fine particle dispersion was applied to have a thickness of 100 μm, and dried at 110 °C for 15 minutes. After mounting a semiconductor chip, it was set in a sintering apparatus. Sintering was performed under a reduced pressure atmosphere (oxygen concentration less than or equal to 1,000 ppm), at 300 °C, under a pressure of 10 MPa for 15 minutes.

[Example 1-2] (not covered by the invention as defined in the claims)

It was carried out with a method similar to Example 1-1, except that a further heat treatment was performed after sintering. The heat treatment was performed at 500 °C for 30 minutes.

[Example 1-3] (not covered by the invention as defined in the claims)

It was carried out with a method similar to Example 1-1, except that conditions of a surface treatment were changed. The surface treatment was, specifically, performed by a wet blast (WB) method using a medium of alumina beads having a particle diameter of 40 μm with a pressure of 0.20 MPa and a processing speed of 10 mm/sec.

[Example 1-4] (not covered by the invention as defined in the claims)

It was carried out with a method similar to Example 1-2, except that a substrate obtained by forming a thin film layer of Ni/Cr/Cu by sputtering and a plating layer on a ceramic plate, in place of a DBC substrate, was used, and a heat treatment was performed before a surface treatment. The heat treatment was performed at 400 °C for 30 minutes.

[Example 1-5] (not covered by the invention as defined in the claims)

It was carried out with a method similar to Example 1-3, except that a further heat treatment was performed after sintering. The heat treatment was performed at 500 °C for 30 minutes.

[Example 1-6] (not covered by the invention as defined in the claims)

It was carried out with a method similar to Example 1-4, except that conditions of a surface treatment were changed and a further heat treatment was not carried out after sintering. The surface treatment was, specifically, performed by a wet blast (WB) method using a medium of alumina beads having a particle diameter of 7 μm with a pressure of 0.2 MPa and a processing speed of 20 mm/sec.

[Example 1-7] (not covered by the invention as defined in the claims)

It was carried out with a method similar to Example 1-1, except that conditions of a surface treatment were changed. The surface treatment was, specifically, performed by a wet blast (WB) method using a medium of alumina beads having a particle diameter of 7 μm with a pressure of 0.2 MPa and a processing speed of 20 mm/sec.

[Example 1-8] (not covered by the invention as defined in the claims)

It was carried out with a method similar to Example 1-4, except that heat treatment before a surface treatment was performed at 400 °C for 15 minutes.

[Example 1-9] (not covered by the invention as defined in the claims)

It was carried out with a method similar to Example 1-1, except that the DBC substrate was replaced with a substrate obtained by forming a thin film layer of Ni/Cr/Cu by sputtering and a plating layer on a ceramic plate.

[Example 1-10] (not covered by the invention as defined in the claims)

It was carried out with a method similar to Example 1-1, except that sintering was performed at 250 °C.

[Example 1-11] (not covered by the invention as defined in the claims)

It was carried out with a method similar to Example 1-2, except that heat treatment was carried out before a surface treatment. The heat treatment was performed at 400 °C for one hour.

[Example 1-12] (not covered by the invention as defined in the claims)

It was carried out with a method similar to Example 1-3, except that heat treatment was further performed after sintering. The heat treatment was performed at 500 °C for 30 minutes.

[Example 1-13] (not covered by the invention as defined in the claims)

It was carried out with a method similar to Example 1-6, except that sintering was performed at 200 °C and heat treatment was further performed after sintering. The heat treatment was performed at 500 °C for 30 minutes.

[Example 1-14] (not covered by the invention as defined in the claims)

It was carried out with a method similar to Example 1-12, except that sintering was performed at 200 °C.

[Example 1-15] (not covered by the invention as defined in the claims)

It was carried out with a method similar to Example 1-13, except that heat treatment was not performed before a surface treatment and sintering was performed at 250 °C.

[Example 1-16] (not covered by the invention as defined in the claims)

It was carried out with a method similar to Example 1-11, except that conditions of a surface treatment were changed and sintering was performed at 200 °C. The surface treatment was, specifically, performed by a wet blast (WB) method using a medium of alumina beads having a particle diameter of 40 μm with a pressure of 0.2 MPa and a processing speed of 20 mm/sec.

[Comparative Example 1-1] (not covered by the invention as defined in the claims)

It was carried out with a method similar to Example 1-1, except that a surface treatment was not performed.

[Comparative Example 1-2] (not covered by the invention as defined in the claims)

It was carried out with a method similar to Example 1-1, except that the surface treatment was changed from a WB process to plasma treatment. Specifically, first, a DBC substrate was set in a chamber of a spattering apparatus and evacuated. Then, Ar gas was introduced into the chamber and the pressure inside the chamber was set at 1 Pa. By supplying electric power using a RF source, Ar plasma was produced near the copper sheet surface of the DBC substrate and irradiated on a copper sheet surface. The condition of an input power of this RF source was 0.25 W/cm$^2$ and irradiation time was five minutes.

[Comparative Example 1-3] (not covered by the invention as defined in the claims)

It was carried out with a method similar to Example 1-10, except that heat treatment was further performed after sintering. The heat treatment was performed at 500 °C for 30 minutes.

[Examples 2-1 to 2-16] (not covered by the invention as defined in the claims)

These were carried out with methods similar to Examples 1-1 to 1-16, except that the metal member was changed from a ceramic substrate to a lead frame material.

[Comparative Example 2-1] (not covered by the invention as defined in the claims)

It was carried out with a method similar to Example 2-2, except that a surface treatment was not performed.

[Comparative Example 2-2] (not covered by the invention as defined in the claims)

It was carried out with a method similar to Example 2-1, except that the surface treatment was changed from a WB process to plasma treatment. The plasma treatment was performed by a method similar to Comparative Example 1-2.

[Examples 3-1 to 3-16] (not covered by the invention as defined in the claims)

A thick copper sheet laminated DBC substrate including a thick copper sheet (metal member) connected to a ceramic substrate via a sintered body was used.
On both upper and lower surfaces of the thick copper sheet of the thick copper sheet laminated DBC substrate, surface treatment and heat treatment were performed in a manner similar to Examples 1-1 to 1-16, and a semiconductor chip was mounted on the thick copper sheet via the metal porous body.

[Example 3-17] (not covered by the invention as defined in the claims)

It was carried out with a method similar to Example 3-1, except that surface treatment was not performed on the ceramic substrate side surface of the thick copper sheet on the metal porous body side of the thick copper sheet laminated DBC substrate, and that surface treatment was performed only on the semiconductor chip side surface of the thick copper sheet.

[Examples 4-1 to 4-16]

These were carried out with methods similar to Examples 1-1 to 1-16, except that the copper fine particle dispersion was changed to a silver particle dispersion, and that sintering was performed in an air atmosphere.

[Comparative Example 4-1 to 4-3] (not covered by the invention as defined in the claims)

These were carried out with methods similar to Comparative Examples 1-1 to 1-3, except that the copper fine particle dispersion was replaced with a silver fine particle dispersion, and that sintering was performed in an air atmosphere.

[Table 1]

[Table 1]

TABLE 1

| | | | EXAMPLE 1-1 | EXAMPLE 1-2 | EXAMPLE 1-3 | EXAMPLE 1-4 | EXAMPLE 1-5 | EXAMPLE 1-6 | EXAMPLE 1-7 | EXAMPLE 1-8 | EXAMPLE 1-9 | EXAMPLE 1-10 |
|---|---|---|---|---|---|---|---|---|---|---|---|---|
| SURFACE TREATMENT CONDITION | METAL SUBSTRATE | TYPE OF SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE |
| | | METAL MEMBER | DBC (COPPER SHEET) | DBC (COPPER SHEET) | DBC (COPPER SHEET) | THIN FILM + PLATING | DBC (COPPER SHEET) | THIN FILM + PLATING | DBC (COPPER SHEET) | THIN FILM + PLATING | THIN FILM + PLATING | DBC (COPPER SHEET) |
| | HEAT TREATMENT (400 °C) | | N/A | N/A | N/A | 0.5h | N/A | 0.5h | N/A | 0.25h | N/A | N/A |
| | SURFACE TREATMENT | | WB | WB | WB STRONG | WB | WB STRONG | WB WEAK | WB WEAK | WB | WB | WB |
| | SURFACE ROUGHNESS Ra ($\mu$m) | | 0.21 | 0.23 | 0.53 | 0.22 | 0.55 | 0.13 | 0.14 | 0.2 | 0.22 | 0.25 |
| JOINING CONDITION | SINTERING TEMPERATURE | | 300 °C | 300 °C | 300 °C | 300 °C | 300 °C | 300 °C | 300 °C | 300 °C | 300 °C | 250 °C |
| | HEAT TREATMENT (500°C, 30 min) | | N/A | YES | N/A | YES | YES | N/A | N/A | YES | N/A | N/A |
| METAL POROUS BODY | CRYSTAL GRAIN SIZE dp ($\mu$m) | | 0.5 | 0.8 | 0.3 | 0.7 | 0.9 | 0.2 | 0.1 | 1 | 0.1 | 0.08 |
| METAL MEMBER | CRYSTAL GRAIN SIZE OF OUTER LAYER ds ($\mu$m) | | 2 | 7 | 6 | 4 | 9 | 0.6 | 0.2 | 1 | 8 | 6 |
| | CRYSTAL GRAIN SIZE OF INNER LAYER di ($\mu$m) | | 33 | 52 | 82 | 20 | 45 | 13 | 82 | 12 | 11 | 82 |
| ds/dp | | | 4 | 9 | 20 | 6 | 10 | 3 | 2 | 1 | 80 | 75 |
| TCT AVERAGE NUMBER OF CYCLES | | | 2550 | 3200 | 4200 | 2840 | 3210 | 2120 | 1650 | 1200 | 1500 | 1130 |

[Table 2]

TABLE 2

| | | | EXAMPLE 1-11 | EXAMPLE 1-12 | EXAMPLE 1-13 | EXAMPLE 1-14 | EXAMPLE 1-15 | EXAMPLE 1-16 | COMPARATIVE EXAMPLE 1-1 | COMPARATIVE EXAMPLE 1-2 | COMPARATIVE EXAMPLE 1-3 |
|---|---|---|---|---|---|---|---|---|---|---|---|
| SURFACE TREATMENT CONDITION | METAL SUBSTRATE | TYPE OF SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE |
| | | METAL MEMBER | DBC (COPPER SHEET) | DBC (COPPER SHEET) | THIN FILM + PLATING | DBC (COPPER SHEET) | THIN FILM + PLATING | DBC (COPPER SHEET) | DBC (COPPER SHEET) | DBC (COPPER SHEET) | THIN FILM + PLATING |
| | HEAT TREATMENT (400 °C) | | 1h | N/A | 0.5h | N/A | N/A | 1h | N/A | N/A | N/A |
| | SURFACE TREATMENT | | WB | WB STRONG | WB WEAK | WB STRONG | WB WEAK | WB STRONG | N/A | PLASMA | WB |
| | SURFACE ROUGHNESS Ra ($\mu$m) | | 0.21 | 0.54 | 0.12 | 0.55 | 0.11 | 0.53 | 1.77 | 1.74 | - |
| JOINING CONDITION | SINTERING TEMPERATURE | | 300 °C | 300 °C | 200 °C | 200 °C | 250 °C | 200 °C | 300 °C | 300 °C | - |
| | HEAT TREATMENT (500°C, 30 min) | | YES | YES | YES | YES | YES | YES | N/A | N/A | YES |
| METAL POROUS BODY | CRYSTAL GRAIN SIZE dp ($\mu$m) | | 1.1 | 0.3 | 0.1 | 0.2 | 0.3 | 0.8 | 0.3 | 0.3 | 0.7 |
| METAL MEMBER | CRYSTAL GRAIN SIZE OF OUTER LAYER ds ($\mu$m) | | 9 | 14 | 0.18 | 22 | 4 | 9 | 75 | 72 | 20 |
| | CRYSTAL GRAIN SIZE OF INNER LAYER di ($\mu$m) | | 90 | 82 | 20 | 82 | 9 | 106 | 75 | 72 | 4 |
| ds/dp | | | 8 | 47 | 2 | 110 | 13 | 11 | 250 | 240 | 29 |
| TCT AVERAGE NUMBER OF CYCLES | | | 1110 | 1090 | 1120 | 1010 | 1080 | 1110 | 600 | 580 | 510 |

[Table 3]

[Table 3]

TABLE 3

| | | EXAMPLE 2-1 | EXAMPLE 2-2 | EXAMPLE 2-3 | EXAMPLE 2-4 | EXAMPLE 2-5 | EXAMPLE 2-6 | EXAMPLE 2-7 | EXAMPLE 2-8 | EXAMPLE 2-9 | EXAMPLE 2-10 |
|---|---|---|---|---|---|---|---|---|---|---|---|
| SURFACE TREATMENT CONDITION | METAL MEMBER | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL |
| | HEAT TREATMENT (400 °C) | N/A | N/A | N/A | 0.5h | N/A | 0.5h | N/A | 0.25h | N/A | N/A |
| | SURFACE TREATMENT | WB | WB | WB STRONG | WB | WB STRONG | WB WEAK | WB WEAK | WB | WB | WB |
| | SURFACE ROUGHNESS Ra ($\mu$m) | 0.22 | 0.23 | 0.53 | 0.22 | 0.55 | 0.13 | 0.14 | 0.2 | 0.22 | 0.25 |
| JOINING CONDITION | SINTERING TEMPERATURE | 300 °C | 300 °C | 300 °C | 300 °C | 300 °C | 300 °C | 300 °C | 300 °C | 300 °C | 250 °C |
| | HEAT TREATMENT (500°C, 30 min) | N/A | YES | N/A | YES | YES | N/A | N/A | YES | N/A | N/A |
| METAL POROUS BODY | CRYSTAL GRAIN SIZE dp ($\mu$m) | 0.4 | 0.7 | 0.3 | 0.7 | 0.9 | 0.2 | 0.1 | 1 | 0.1 | 0.08 |
| METAL MEMBER | CRYSTAL GRAIN SIZE OF OUTER LAYER ds ($\mu$m) | 2 | 8 | 6 | 4 | 9 | 0.7 | 0.2 | 1 | 8 | 6 |
| | CRYSTAL GRAIN SIZE OF INNER LAYER di ($\mu$m) | 36 | 50 | 84 | 19 | 46 | 13 | 80 | 13 | 11 | 84 |
| ds/dp | | 5 | 11 | 20 | 6 | 10 | 4 | 2 | 1 | 80 | 75 |

EP 3 057 123 B1

17

(continued)

| | EXAMPLE 2-1 | EXAMPLE 2-2 | EXAMPLE 2-3 | EXAMPLE 2-4 | EXAMPLE 2-5 | EXAMPLE 2-6 | EXAMPLE 2-7 | EXAMPLE 2-8 | EXAMPLE 2-9 | EXAMPLE 2-10 |
|---|---|---|---|---|---|---|---|---|---|---|
| TCT AVERAGE NUMBER OF CYCLES | 780 | 840 | 900 | 820 | 850 | 730 | 700 | 650 | 660 | 640 |

[Table 4]

[Table 4]

TABLE 4

| | | EXAMPLE 2-11 | EXAMPLE 2-12 | EXAMPLE 2-13 | EXAMPLE 2-14 | EXAMPLE 2-15 | EXAMPLE 2-16 | COMPARATIVE EXAMPLE 2-1 | COMPARATIVE EXAMPLE 2-2 |
|---|---|---|---|---|---|---|---|---|---|
| SURFACE TREATMENT CONDITION | METAL MEMBER | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL | LEAD FRAME MATERIAL |
| | HEAT TREATMENT (400 °C) | 1h | N/A | 0.5h | N/A | N/A | 1h | N/A | N/A |
| | SURFACE TREATMENT | WB | WB STRONG | WB WEAK | WB STRONG | WB WEAK | WB STRONG | N/A | PLASMA |
| | SURFACE ROUGHNESS Ra ($\mu$m) | 0.21 | 0.54 | 0.12 | 0.55 | 0.11 | 0.53 | 0.07 | 0.08 |
| JOINING CONDITION | SINTERING TEMPERATURE | 300 °C | 300 °C | 200 °C | 200 °C | 250 °C | 200 °C | 300 °C | 300 °C |
| | HEAT TREATMENT (500°C, 30 min) | YES | YES | YES | YES | YES | YES | YES | N/A |
| METAL POROUS BODY | CRYSTAL GRAIN SIZE dp ($\mu$m) | 1.1 | 0.3 | 0.1 | 0.2 | 0.4 | 0.8 | 0.3 | 0.3 |
| METAL MEMBER | CRYSTAL GRAIN SIZE OF OUTER LAYER ds ($\mu$m) | 9 | 15 | 0.18 | 22 | 5 | 9 | 45 | 43 |
| | CRYSTAL GRAIN SIZE OF INNER LAYER di ($\mu$m) | 91 | 84 | 22 | 82 | 9 | 108 | 45 | 43 |
| ds/dp | | 8 | 50 | 2 | 110 | 13 | 11 | 150 | 143.3 |
| TCT AVERAGE NUMBER OF CYCLES | | 630 | 620 | 630 | 610 | 620 | 630 | 330 | 410 |

[Table 5]

[Table 5]

TABLE 5

| | | | EXAMPLE 3-1 | EXAMPLE 3-2 | EXAMPLE 3-3 | EXAMPLE 3-4 | EXAMPLE 3-5 | EXAMPLE 3-6 | EXAMPLE 3-7 | EXAMPLE 3-8 | EXAMPLE 3-9 | EXAMPLE 3-10 |
|---|---|---|---|---|---|---|---|---|---|---|---|---|
| SURFACE TREATMENT CONDITION | METAL SUBSTRATE | TYPE OF SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE |
| | | METAL MEMBER | THICK COPPER SHEET | THICK COPPER SHEET | THICK COPPER SHEET | THICK COPPER SHEET | THICK COPPER SHEET | THICK COPPER SHEET | THICK COPPER SHEET | THICK COPPER SHEET | THICK COPPER SHEET | THICK COPPER SHEET |
| | HEAT TREATMENT (400 °C) | | N/A | N/A | N/A | 0.5h | N/A | 0.5h | N/A | 0.25h | N/A | N/A |
| | SURFACE TREATMENT | | WB | WB | WB STRONG | WB | WB STRONG | WB WEAK | WB WEAK | WB | WB | WB |
| | SURFACE ROUGHNESS Ra ($\mu$m) | | 0.21 | 0.23 | 0.53 | 0.22 | 0.55 | 0.13 | 0.14 | 0.2 | 0.22 | 0.25 |
| JOINING CONDITION | SINTERING TEMPERATURE | | 300 °C | 300 °C | 300 °C | 300 °C | 300 °C | 300 °C | 300 °C | 300 °C | 300 °C | 250 °C |
| | HEAT TREATMENT (500°C, 30 min) | | N/A | YES | N/A | YES | YES | N/A | N/A | YES | N/A | N/A |
| METAL POROUS BODY | CRYSTAL GRAIN SIZE dp ($\mu$m) | | 0.4 | 0.8 | 0.3 | 0.7 | 0.9 | 0.2 | 0.1 | 1 | 0.1 | 0.08 |
| METAL MEMBER | CRYSTAL GRAIN SIZE OF OUTER LAYER ds ($\mu$m) | | 2.2 | 8 | 6 | 4 | 9 | 0.6 | 0.2 | 1 | 8 | 6 |
| | CRYSTAL GRAIN SIZE OF INNER LAYER di ($\mu$m) | | 36 | 45 | 82 | 20 | 45 | 13 | 82 | 12 | 11 | 82 |
| ds/dp | | | 6 | 10 | 20 | 6 | 10 | 3 | 2 | 1 | 80 | 75 |
| TCT AVERAGE NUMBER OF CYCLES | | | 3550 | 4200 | 5250 | 3800 | 4260 | 3100 | 2600 | 2100 | 2410 | 2050 |

EP 3 057 123 B1

[Table 6]

[Table 6]

TABLE 6

| | | | EXAMPLE 3-11 | EXAMPLE 3-12 | EXAMPLE 3-13 | EXAMPLE 3-14 | EXAMPLE 3-15 | EXAMPLE 3-16 | EXAMPLE 3-17 |
|---|---|---|---|---|---|---|---|---|---|
| SURFACE TREATMENT CONDITION | METAL SUBSTRATE | TYPE OF SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE | LAMINATED DBC SUBSTRATE |
| | | METAL MEMBER | THICK COPPER SHEET | THICK COPPER SHEET | THICK COPPER SHEET | THICK COPPER SHEET | THICK COPPER SHEET | THICK COPPER SHEET | THICK COPPER SHEET |
| | HEAT TREATMENT (400 °C) | | 1h | N/A | 0.5h | N/A | N/A | 1h | N/A |
| | SURFACE TREATMENT | | WB | WB STRONG | WB WEAK | WB STRONG | WB WEAK | WB STRONG | WB |
| | SURFACE ROUGHNESS Ra ($\mu$m) | | 0.21 | 0.54 | 0.12 | 0.55 | 0.11 | 0.53 | 0.21 |
| JOINING CONDITION | SINTERING TEMPERATURE | | 300 °C | 300 °C | 200 °C | 200 °C | 250 °C | 200 °C | 300 °C |
| | HEAT TREATMENT (500°C, 30 min) | | YES | YES | YES | YES | YES | YES | N/A |
| METAL POROUS BODY | CRYSTAL GRAIN SIZE dp ($\mu$m) | | 1.1 | 0.3 | 0.1 | 0.2 | 0.3 | 0.8 | 0.3 |
| METAL MEMBER | CRYSTAL GRAIN SIZE OF OUTER LAYER ds ($\mu$m) | | 9 | 14 | 0.18 | 22 | 4 | 9 | 2.2 |
| | CRYSTAL GRAIN SIZE OF INNER LAYER di ($\mu$m) | | 90 | 82 | 20 | 82 | 9 | 106 | 17 |
| ds/dp | | | 8 | 47 | 2 | 110 | 13 | 11 | 7 |
| TCT AVERAGE NUMBER OF CYCLES | | | 2020 | 2010 | 2030 | 2000 | 2010 | 2020 | 1750 |

EP 3 057 123 B1

24

[Table 7]

TABLE 7

| | | | EXAMPLE 4-1 | EXAMPLE 4-2 | EXAMPLE 4-3 | EXAMPLE 4-4 | EXAMPLE 4-5 | EXAMPLE 4-6 | EXAMPLE 4-7 | EXAMPLE 4-8 | EXAMPLE 4-9 | EXAMPLE 4-10 |
|---|---|---|---|---|---|---|---|---|---|---|---|---|
| SURFACE TREATMENT CONDITION | METAL SUBSTRATE | TYPE OF SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE |
| | | METAL MEMBER | DBC (COPPER SHEET) | DBC (COPPER SHEET) | DBC (COPPER SHEET) | THIN FILM + PLATING | DBC (COPPER SHEET) | THIN FILM + PLATING | DBC (COPPER SHEET) | THIN FILM + PLATING | THIN FILM + PLATING | DBC (COPPER SHEET) |
| | HEAT TREATMENT (400 °C) | | N/A | N/A | N/A | 0.5h | N/A | 0.5h | N/A | 0.25h | N/A | N/A |
| | SURFACE TREATMENT | | WB | WB | WB STRONG | WB | WB STRONG | WB WEAK | WB WEAK | WB | WB | WB |
| | SURFACE ROUGHNESS Ra ($\mu$m) | | 0.21 | 0.23 | 0.53 | 0.22 | 0.55 | 0.13 | 0.14 | 0.2 | 0.22 | 0.25 |
| JOINING CONDITION | SINTERING TEMPERATURE | | 300 °C | 300 °C | 300 °C | 300 °C | 300 °C | 300 °C | 300 °C | 300 °C | 300 °C | 250 °C |
| | HEAT TREATMENT (500°C, 30 min) | | N/A | YES | N/A | YES | YES | N/A | N/A | YES | N/A | N/A |
| METAL POROUS BODY | CRYSTAL GRAIN SIZE dp ($\mu$m) | | 0.4 | 0.2 | 0.2 | 0.6 | 0.8 | 0.2 | 0.1 | 1.0 | 0.1 | 0.07 |
| METAL MEMBER | CRYSTAL GRAIN SIZE OF OUTER LAYER ds ($\mu$m) | | 2 | 8 | 6 | 4 | 9 | 0.6 | 0.2 | 1 | 8 | 6 |
| | CRYSTAL GRAIN SIZE OF INNER LAYER di ($\mu$m) | | 73 | 48 | 82 | 20 | 45 | 13 | 82 | 12 | 11 | 82 |
| ds/dp | | | 5 | 40 | 30 | 7 | 11 | 3 | 2 | 1 | 80 | 86 |
| TCT AVERAGE NUMBER OF CYCLES | | | 2520 | 3100 | 4000 | 2420 | 3100 | 2050 | 1450 | 1120 | 1250 | 1090 |

EP 3 057 123 B1

26

EP 3 057 123 B1

[Table 8]

[Table 8]

27

TABLE 8

| | | EXAMPLE 4-11 | EXAMPLE 4-12 | EXAMPLE 4-13 | EXAMPLE 4-14 | EXAMPLE 4-15 | EXAMPLE 4-16 | COMPARATIVE EXAMPLE 4-1 | COMPARATIVE EXAMPLE 4-2 | COMPARATIVE EXAMPLE 4-3 |
|---|---|---|---|---|---|---|---|---|---|---|
| SURFACE TREATMENT CONDITION | METAL SUBSTRATE — TYPE OF SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE | CERAMIC SUBSTRATE |
| | METAL SUBSTRATE — METAL MEMBER | DBC (COPPER SHEET) | DBC (COPPER SHEET) | THIN FILM + PLATING | DBC (COPPER SHEET) | THIN FILM + PLATING | DBC (COPPER SHEET) | DBC (COPPER SHEET) | DBC (COPPER SHEET) | THIN FILM + PLATING |
| | HEAT TREATMENT (400 °C) | 1h | N/A | 0.5h | N/A | N/A | 1h | N/A | N/A | N/A |
| | SURFACE TREATMENT | WB | WB STRONG | WB WEAK | WB STRONG | WB WEAK | WB STRONG | N/A | PLASMA | WB |
| | SURFACE ROUGHNESS Ra (μm) | 0.21 | 0.54 | 0.12 | 0.55 | 0.11 | 0.53 | 1.77 | 1.74 | - |
| JOINING CONDITION | SINTERING TEMPERATURE | 300 °C | 300 °C | 200 °C | 200 °C | 250 °C | 200 °C | 300 °C | 300 °C | - |
| | HEAT TREATMENT (500 °C, 30 min) | YES | YES | YES | YES | YES | YES | N/A | N/A | YES |
| METAL POROUS BODY | CRYSTAL GRAIN SIZE dp (μm) | 1.1 | 0.2 | 0.1 | 0.2 | 0.3 | 0.7 | 0.1 | 0.2 | 0.7 |
| METAL MEMBER | CRYSTAL GRAIN SIZE OF OUTER LAYER ds (μm) | 9 | 14 | 0.18 | 23 | 3 | 9 | 75 | 72 | 20 |
| | CRYSTAL GRAIN SIZE OF INNER LAYER di (μm) | 90 | 82 | 20 | 82 | 9 | 106 | 75 | 72 | 4 |
| | ds/dp | 8 | 70 | 2 | 115 | 10 | 13 | 750 | 360 | 29 |
| | TCT AVERAGE NUMBER OF CYCLES | 1100 | 1040 | 1020 | 1010 | 1050 | 1070 | 590 | 530 | 500 |

As shown in Tables 1 and 2, an average number of cycles in TCT was greater than or equal to 1000 for each of Examples 1-1 to 1-16, and it can be seen that crack occurrence preventing property was good. Particularly, an average number of cycles in TCT was greater than or equal to 1500 for each of Examples 1-1 to 1-9, and thus it can be seen that crack occurrence preventing property was particularly excellent. On the other hand, an average number of cycles in TCT was 600 and 580, which are small, for Comparative Examples 1-1 and 1-2 in which the crystal grain size of the outer layer and the crystal grain size of the inner layer were the same. An average number of cycles in TCT was 510, which is very small, for Comparative Example 1-3 in which the crystal grain size of the outer layer was greater than the crystal grain size of the inner layer.

As shown in Tables 3 and 4, an average number of cycles in TCT was greater than or equal to 600 for each of Examples 2-1 to 2-16, and it can be seen that crack occurrence preventing property was good. Particularly, an average number of cycles in TCT was greater than or equal to 650 for each of Examples 2-1 to 2-9, and thus it can be seen that crack occurrence preventing property was particularly excellent. On the other hand, an average number of cycles in TCT was 330 and 410, which are small, for Comparative Examples 2-1 and 2-2 in which the crystal grain size of the outer layer and the crystal grain size of the inner layer were the same.

As shown in Tables 5 and 6, an average number of cycles in TCT was greater than or equal to 1000 for each of Examples 3-1 to 3-17, and it can be seen that crack occurrence preventing property was good. Particularly, an average number of cycles in TCT was greater than or equal to 2000 for each of Examples 3-1 to 3-16, and thus it can be seen that crack occurrence preventing property was extremely excellent.

As shown in Tables 7 and 8, an average number of cycles in TCT was greater than or equal to 1000 for each of Examples 4-1 to 4-16, and it can be seen that crack occurrence preventing property was excellent. On the other hand, an average number of cycles in TCT was 590 and 530, which are small, for Comparative Examples 4-1 and 4-2 in which the crystal grain size of the outer layer and the crystal grain size of the inner layer were the same. An average number of cycles in TCT was 500, which is very small, for Comparative Example 4-3 in which the crystal grain size of the outer layer was greater than the crystal grain size of the inner layer.

List of Reference Signs

1 metal member
1a main surface
1b outer layer
1c inner layer
2, 3, 5, 6 metal porous body
4 thick copper sheet
7, 9 copper sheet
8 ceramic sheet
21 lower heating platen
22 pressing plate
23 laminated body
24 chamber
25 pressure cylinder
26 upper heating platen

**Claims**

1. A joining structure comprising: a ceramic substrate (8); a metal member (1,7) made of copper, being a metal layer formed directly on the ceramic substrate (8) or a metal layer formed directly on a metal thin film, the metal thin film being formed directly on the ceramic substrate (8);

    a metal porous body (2, 6) made of silver formed directly on the metal member (1, 7) and a semiconductor chip (10) disposed on the metal porous body (2, 6), whereby the semiconductor chip (10) is joined to the metal member (1, 7) via the metal porous body (2, 6), wherein the metal member (1, 7) consists of an inner layer (1c) and an outer layer (1b) directly on the inner layer (1c), the first outer layer (1b) including at least one of main surfaces of the metal member (1,7) and being formed on the metal porous body side of the metal member (1,7), the inner layer (1c) being formed at a position farther from the metal porous body (2, 6) than the outer layer (1b) in a thickness direction and the metal porous body (2, 6) being joined directly to the first outer layer (1b),

**characterized in that** the outer layer (1b) has an average crystal grain size (ds) that is smaller than an average crystal grain size (di) of the inner layer (1c), and the metal porous body (2, 6) has an average crystal grain size (dp) that is smaller than or equal to the average crystal grain size (ds) of the outer layer (1b), said average crystal grain sizes being obtained in following manner: for obtaining the average crystal grain size (dp) of the metal porous body (2, 6), in an image, a straight line (a) is drawn in the middle of the thickness direction of the metal porous body (2, 6), and an average value of (length+ width)/2 for crystals existing on the straight line (a) is calculated;

for obtaining the average crystal grain size (ds) of the outer layer (1b), in an image, at a position at a distance of 1$\mu$m in the thickness direction from an interface between the metal porous body (2, 6) and the metal member (1, 7) to the metal member (1, 7) side, a line (c) is drawn along the interface, and an average value of (length+ breadth)/2 for crystals existing on the line (c) is calculated;

and for obtaining the average crystal grain size (di) of the inner layer (1c), in an image, a straight line (d) is drawn in the middle of the thickness direction of the metal member (1, 7), and an average value of (length+ breadth)/2 for crystals existing on the straight line (d) is calculated.

2. The joining structure according to claim 1, **characterized in that** the average crystal grain size (ds) of the outer layer (1b) and the average crystal grain size (dp) of the metal porous body (2, 6) satisfies:

3. The joining structure according to claim 1 or 2, **characterized in that** the average crystal grain size (ds) of the outer layer (1b) is greater than or equal to 0.2 $\mu$m and less than 10 $\mu$m.

4. The joining structure according to any one of claims 1 to 3, **characterized in that** the average crystal grain size (di) of the inner layer (1c) is greater than or equal to 10 $\mu$m and less than 100 $\mu$m.

5. The joining structure according to any one of claims 1 to 4, **characterized in that** the average crystal grain size (dp) of the metal porous body (2, 6) is greater than or equal to 0.1 $\mu$m and less than or equal to 1 $\mu$m.

6. The joining structure according to any one of claims 1 to 5, **characterized by** further comprising an electrode layer including one or more of Au, Ag, Cu, Pd and Pt between the metal porous body (2, 6) and the semiconductor chip (10).

**Patentansprüche**

1. Verbindungsstruktur umfassend: ein keramisches Substrat (8); ein Metallteil (1, 7) aus Kupfer, welches eine direkt auf dem keramischen Substrat (8) angeordnete Schicht oder eine Metallschicht ist, die direkt auf einem metallischen Dünnfilm ausgebildet ist, welcher metallische Dünnfilm direkt auf dem keramischen Substrat (8) angeordnet ist; ein poröser Metallkörper (2, 6) aus Silber, der direkt auf dem Metallteil (1, 7) ausgebildet ist, und einen Halbleiterchip (10), der auf dem porösen Metallkörper (2, 6) angeordnet ist, wobei der Halbleiterchip (10) mit dem Metallteil (1, 7) über den porösen Metallkörper (2, 6) verbunden ist, wobei das Metallteil (1, 7) aus einer inneren Lage (1c) und einer äußeren Lage (1b) besteht, die direkt auf der inneren Lage (1c) angeordnet ist, wobei die äußere Lage (1b) wenigstens eine der Hauptflächen des Metallteils (1, 7) enthält und auf der dem porösen Metallkörper zugewandten Seite des Metallteils (1, 7) ausgebildet ist, wobei die innere Lage (1c) in Dickenrichtung in einer Position weiter entfernt von dem porösen Metallkörper (2, 6) angeordnet ist als die äußere Lage (1b) und der poröse Metallkörper (2, 6) direkt mit der äußeren Lage (1b) verbunden ist, **dadurch gekennzeichnet, dass** die äußere Lage (1b) eine durchschnittliche Korngröße (ds) aufweist, die geringer ist als die durchschnittliche Korngröße (di) der inneren Lage (1c), und dass der poröse Metallkörper (2, 6) eine durchschnittliche Kristallkorngröße (dp) aufweist, die kleiner oder gleich der durchschnittlichen Kristallkorngröße (ds) der äußeren Lage (1b) ist, wobei die durchschnittlichen Kristallkorngrößen auf folgende Weise erhalten werden: Zum Erhalt der durchschnittlichen Kristallkorngröße (dp) des porösen Metallkörpers (2, 6) in einem Bild wird eine gerade Linie (a) in der Mitte der Dickenrichtung des porösen Metallkörpers (2, 6) gezeichnet und ein Durchschnittswert (Länge + Breite)/2 für Kristalle, die auf der geraden Linie (a) liegen, wird ausgerechnet;

zum Erhalten der durchschnittlichen Kristallkorngröße (ds) der äußeren Lage (1b) wird in einem Bild in einer Position in einem Abstand von 1 $\mu$m in Dickenrichtung von der Grenzfläche zwischen dem porösen Metallkörper (2, 6) und dem Metallteil (1, 7) zur Seite des Metallteils (1, 7) eine Linie (c) entlang der Grenzfläche gezeichnet, und ein Durchschnittswert (Länge + Breite)/2 für die auf der Linie (c) liegenden Kristalle wird berechnet; und zum Erhalten der durchschnittlichen Kristallkorngröße (d) der inneren Lage (1c) wird in einem Bild eine gerade Linie (d) in der Mitte der Dickenrichtung des Metallteils (1, 7) gezeichnet und ein Durchschnittswert (Länge + Breite)/2 für die auf der geraden Linie (d) liegenden Kristalle wird berechnet.

2. Verbindungsstruktur nach Anspruch 1, **dadurch gekennzeichnet, dass** die durchschnittliche Kristallkorngröße (ds) der äußeren Lage (1b) und die durchschnittliche Kristallkorngröße (dp) des porösen Metallkörpers (2, 6) folgende Bedingung erfüllt:

$$1 \leq ds/dp < 100.$$

3. Verbindungsstruktur nach Anspruch 1 oder 2, **dadurch gekennzeichnet, dass** die durchschnittliche Kristallkorngröße (ds) der äußeren Lage (1b) größer oder gleich 0,2 $\mu$m und kleiner als 10 $\mu$m ist.

4. Verbindungsstruktur nach einem der Ansprüche 1 bis 3, **dadurch gekennzeichnet, dass** die durchschnittliche Kristallkomgröße (di) der inneren Lage (1c) größer oder gleich 10 $\mu$m und kleiner als 100 $\mu$m ist.

5. Verbindungsstruktur nach einem der Ansprüche 1 bis 4, **dadurch gekennzeichnet, dass** die durchschnittliche Kristallkorngröße (dp) des porösen Metallkörpers (2, 6) größer oder gleich 0,1 $\mu$m und kleiner oder gleich 1 $\mu$m ist.

6. Verbindungsstruktur nach einem der Ansprüche 1 bis 5, **dadurch gekennzeichnet, dass** sie weiterhin eine Elektrodenschicht enthält, die zwischen dem porösen Metallkörper (2, 6) und dem Halbleiterchip (10) angeordnet ist und einen oder mehrere der folgenden Bestandteile enthält: Au, Ag, Cu, Pd und Pt.

**Revendications**

1. Structure d'interconnexion comprenant :

un substrat (8) en céramique ;
un élément métallique (1, 7) fabriqué en cuivre, étant une couche métallique formée directement sur le substrat (8) en céramique ou une couche métallique formée directement sur un film mince métallique, le film mince métallique étant formé directement sur le substrat (8) en céramique ;
un corps poreux (2, 6) métallique, fabriqué en argent formé directement sur l'élément métallique (1, 7) ; et
une puce à semi-conducteur (10) disposée sur le corps poreux (2, 6) métallique, la puce à semi-conducteur (10) étant assemblée à l'élément métallique (1, 7) par le biais du corps poreux (2, 6) métallique,
dans laquelle l'élément métallique (1, 7) est constitué d'une couche intérieure (1c) et d'une couche extérieure (1b) directement sur la couche intérieure (1c), la couche extérieure (1b) comportant au moins une des surfaces principales de l'élément métallique (1, 7) et étant formée sur le côté du corps poreux métallique de l'élément métallique (1, 7), la couche intérieure (1c) étant formée à un endroit plus éloigné du corps poreux (2, 6) métallique que la couche extérieure (1b) dans une direction d'épaisseur et le corps poreux (2, 6) métallique étant assemblé directement à la couche extérieure (1b),
**caractérisée en ce que** la couche extérieure (1b) possède une taille de grain cristallin moyenne (ds) qui est inférieure à une taille de grain cristallin moyenne (di) de la couche intérieure (1c), et
le corps poreux (2, 6) métallique possède une taille de grain cristallin moyenne (dp) qui est inférieure ou égale à la taille de grain cristallin moyenne (ds) de la couche extérieure (1b),
lesdites tailles de grain cristallin moyennes étant obtenues de la manière suivante :

pour obtenir la taille de grain cristallin moyenne (dp) du corps poreux (2, 6) métallique, dans une image, on trace une ligne droite (a) au milieu de la direction d'épaisseur du corps poreux (2, 6) métallique et une valeur moyenne de (longueur + largeur)/2 pour des cristaux existant sur la ligne droite (a) est calculée ;
pour obtenir la taille de grain cristallin moyenne (ds) de la couche extérieure (1b), dans une image, à un endroit à une distance de 1 $\mu$m dans la direction de l'épaisseur à partir de l'interface entre le corps poreux (2, 6) métallique et l'élément métallique (1, 7), par rapport au côté de l'élément métallique (1, 7), on trace une ligne (c) le long de l'interface, et une valeur moyenne de (longueur + profondeur)/2 pour des cristaux existants sur la ligne (c) est calculée ;
et pour obtenir la taille de grain cristallin moyenne (di) de la couche intérieure (1c), dans une image, on trace une ligne droite (d) au milieu de la direction d'épaisseur de l'élément métallique (1, 7) et une valeur moyenne de (longueur + profondeur)/2 pour des cristaux existants sur la ligne droite (d) est calculée.

**2.** Structure d'interconnexion selon la revendication 1, **caractérisée en ce que** la taille de grain cristallin moyenne (ds) de la couche extérieure (1b) et la taille de grain cristallin moyenne (dp) du corps poreux (2, 6) métallique satisfont à :

$$1 \leq ds/dp < 100.$$

**3.** Structure d'interconnexion selon la revendication 1 ou la revendication 2, **caractérisée en ce que** la taille de grain cristallin moyenne (ds) de la couche extérieure (1b) est supérieure ou égale à 0,2 $\mu$m et inférieure à 10 $\mu$m.

**4.** Structure d'interconnexion selon l'une quelconque des revendications 1 à 3, **caractérisée en ce que** la taille de grain cristallin moyenne (di) de la couche intérieure (1c) est supérieure ou égale à 10 $\mu$m et inférieure à 100 $\mu$m.

**5.** Structure d'interconnexion selon l'une quelconque des revendications 1 à 4, **caractérisée en ce que** la taille de grain cristallin moyenne (dp) du corps poreux (2, 6) métallique est supérieure ou égale à 0,1 $\mu$m et inférieure à 1 $\mu$m.

**6.** Structure d'interconnexion selon l'une quelconque des revendications 1 à 5, **caractérisée** comme comprenant en outre une couche d'électrode comportant un ou plusieurs métaux parmi Au, Ag, Cu, Pd et Pt entre le corps poreux (2, 6) métallique et la puce semi-conductrice (10).

F I G. 1

F I G. 2

FIG. 3A       FIG. 3B       FIG. 3C

## Fig. 4A

(a)

## Fig. 4B

(b)

F I G. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004107728 A
- JP 2008208442 A
- JP 2013524494 A
- EP 2388810 A2
- WO 2012029772 A1